# EUROPÄISCHE PATENTSCHRIFT

(11) **EP 2 283 520 B1**
(45) Veröffentlichungstag und Bekanntmachung des Hinweises auf die Patenterteilung: **26.09.2018**
(21) Anmeldenummer: 09749489.2
(22) Anmeldetag: 13.05.2009
(51) Int. Cl.: H01L 27/15

(54) **OPTOELEKTRONISCHES MODUL**
OPTOELECTRONIC MODULE
MODULE OPTOÉLECTRONIQUE

(30) Priorität: 23.05.2008 DE 102008024927; 30.09.2008 DE 102008049777
(43) Veröffentlichungstag der Anmeldung: 16.02.2011
(73) Patentinhaber: OSRAM Opto Semiconductors GmbH, 93055 Regensburg (DE)
(72) Erfinder: EISSLER, Dieter, 93152 Nittendorf / Etterzhausen (DE); HERRMANN, Siegfried, 94362 Neukirchen (DE)
(74) Vertreter: Epping - Hermann - Fischer
(86) Internationale Anmeldenummer: PCT/DE2009/000679
(87) Internationale Veröffentlichungsnummer: WO 2009/140947

(56) Entgegenhaltungen:
- US-A- 5 789 766
- US-B1- 6 355 945
- US-B1- 6 410 941

## Beschreibung

Die Erfindung betrifft ein optoelektronisches Modul, das eine integrierte Schaltung zur Steuerung einer Licht emittierenden Struktur enthält. Die Erfindung betrifft des Weiteren eine optoelektronische Modulanordnung aus mehreren derartigen optoelektronischen Modulen. Die Erfindung betrifft außerdem ein Verfahren zur Herstellung eines optoelektronischen Moduls.

Zur effektiven Beleuchtung von Objekten werden optoelektronische Module verwendet, die mehrere Licht emittierende Bauelemente aufweisen. Die Licht emittierenden Bauelemente können beispielsweise LEDs (light emitting diode) sein, die auf einer Modulplatine des Moduls befestigt und elektrisch kontaktiert sind. Die Beschaltung der Module geschieht meist in Hybridtechnik, wobei die einzeln gesetzten Licht emittierenden Bauelemente sich auch auf mehreren Modulplatinen verteilen können. Zur Steuerung der Lichtemission der Licht emittierenden Bauelemente werden Regel- und Steuerschaltungen eingesetzt. Die Steuerung der LEDs kann beispielsweise mittels Sensoren erfolgen, die als diskrete Bauelemente auf der Modulplatine aufgebracht sind. Die diskreten Bauelemente weisen ein Gehäuse auf, in denen ein Chip angeordnet ist. Die Modulplatine ist somit neben den LED-Chips zum Beispiel mit Bauteilen bestückt, in deren Gehäuse Chips mit Sensoren zur Licht-, Temperatur- oder Farbpunktmessung angeordnet sind.

Die Ansteuer- und Regelelektronik sowie die Sensoren und Hochleistungswärmesenken sind nicht auf oder in dem Modul, auf dem die Licht emittierenden Bauelemente angeordnet sind, integriert.

Eine Aufgabe der vorliegenden Erfindung ist es, ein 1 optoelektronisches Modul anzugeben, mit dem es ermöglicht wird, die Lichterzeugung von Licht emittierenden Strukturen auf effektive Art zu steuern. Eine weitere Aufgabe der vorliegenden Erfindung ist es, ein optoelektronisches Modul anzugeben, bei dem die Lichterzeugung von Licht emittierenden Strukturen auf effektive Art gesteuert wird. Eine weitere Aufgabe der vorliegenden Erfindung ist es, ein Verfahren zur Herstellung eines derartigen optoelektronischen Moduls anzugeben.

Ein optoelektronisches Modul weist eine Schichtstruktur mit mehreren Halbleiterschichten auf, wobei die mehreren Halbleiterschichten eine Substratschicht, eine erste Schichtanordnung und mindestens eine zweite Schichtanordnung umfassen. Die erste Schichtanordnung weist eine Licht emittierende Schicht auf, die auf der Substratschicht angeordnet ist. Die zweite Schichtanordnung enthält mindestens eine Schaltung zur Steuerung eines Betriebszustands der Licht emittierenden Schicht.

Die zweite Schichtanordnung kann auf der Substratschicht angeordnet und/oder von der Substratschicht umgeben sein. Dabei ist es möglich, dass zumindest eine Schaltung der zweiten Schichtanordnung auf der Substratschicht angeordnet ist und zumindest eine Schaltung der zweiten Schichtanordnung von der Substratschicht umgeben ist. Ferner ist es auch möglich, dass sämtliche Schaltungen, das heißt die komplette zweite Schichtanordnung von der Substratschicht umgeben ist. Die zweite Schichtanordnung ist dann vollständig in die Substratschicht integriert und damit Platz sparend angeordnet.

Die zweite Schichtanordnung kann zwei oder eine Vielzahl unterschiedlicher Schaltungen umfassen, die unterschiedliche Aufgaben im Modul übernehmen.

Dabei ist es möglich, dass zumindest eine der Schaltungen von der Substratschicht vollständig umgeben ist und zumindest eine der Schaltungen auf der Substratschicht angeordnet oder teilweise von der Substratschicht umgeben ist. Das heißt, eine der Schaltungen kann in der Substratschicht integriert sein, während eine andere Schaltung zumindest stellenweise frei von der Substratschicht ist.

Die erste Schichtanordnung enthält beispielsweise eine Leuchtdiode, insbesondere eine substratlose Leuchtdiode, eine CSP (chip scale package) -Leuchtdiode, eine organische Leuchtdiode oder eine Hochleistungsleuchtdiode. Eine CSP-Leuchtdiode ist zum Beispiel in der Druckschrift WO 2008/131736 beschrieben, deren Offenbarungsgehalt hiermit durch Rückbezug aufgenommen wird.

Die zweite Schichtanordnung kann eine Schaltung zum Schutz des optoelektronischen Moduls vor einer elektrostatischen Entladung enthalten. Die Schaltung zum Schutz des optoelektronischen Moduls vor einer elektrostatischen Entladung kann durch dotierte Bereiche unter Kontaktanschlüssen zur Kontaktierung der ersten Schichtanordnung gebildet sein.

Die zweite Schichtanordnung kann eine Schaltung zur Steuerung einer Helligkeit oder einer Farbe einer von der Licht emittierenden Schicht der ersten Schichtanordnung emittierten Strahlung enthalten.

Die zweite Schichtanordnung kann des Weiteren eine Schaltung zur Detektion einer Helligkeit der Umgebung der integrierten Schaltung enthalten.

Die zweite Schichtanordnung kann ferner eine Schaltung enthalten, die zur Bereitstellung einer Spannung oder eines Stromes zur Erzeugung einer Strahlung der Licht emittierenden Schicht der ersten Schichtanordnung ausgebildet ist.

Die Substratschicht kann zum Beispiel Silizium oder SiC oder Germanium oder Gallium-Nitrid oder Aluminiumnitrid oder Aluminiumoxid oder Siliziumnitrid oder eine Kombination davon enthalten oder aus einem der Materialien bestehen. Gemäß einer weiteren Ausführungsform kann die Substratschicht als Folie ausgebildet sein.

Im Folgenden wird eine optoelektronische Modulanordnung angegeben. Die optoelektronische Modulanordnung umfasst mehrere integrierte optoelektronische Module nach einer der oben angegebenen Ausführungsformen. Eine der mehreren optoelektronischen Module umfasst eine Schichtanordnung, die auf der Substratschicht des einen der mehreren optoelektronischen Module aufgebracht oder von der Substratschicht des einen der mehreren optoelektronischen Module umgeben ist. Die eine Schichtanordnung enthält eine Schaltung zur Steuerung einer Strahlung, die von den jeweiligen Licht emittierenden Schichten der mehreren optoelektronischen Module emittiert wird.

Die Schichtanordnung kann eine Schaltung zu einer Abstimmung einer Helligkeit, einer Farbe oder einer Farbmischung der Strahlung, die von den jeweiligen Licht emittierenden Schichten der mehreren optoelektronischen Module emittiert wird, enthalten.

Die Schichtanordnung kann beispielsweise eine Schaltung zu einer Funkfernsteuerung der Strahlung, die von den jeweiligen Licht emittierenden Schichten der mehreren optoelektronischen Module emittiert wird, enthalten.

Im Folgenden wird ein Verfahren zur Herstellung eines optoelektronischen Moduls angegeben. Gemäß dem Verfahren wird eine erste Schichtanordnung mit einer Licht emittierenden Schicht auf einer Trägerschicht aufgewachsen. Es wird des Weiteren eine Schichtstruktur mit mehreren Halbleiterschichten bereit gestellt, wobei die mehreren Halbleiterschichten eine Substratschicht und eine zweite Schichtanordnung umfassen, wobei die zweite Schichtanordnung eine Schaltung zur Steuerung eines Betriebszustandes der Licht emittierenden Schicht enthält. Die erste Schichtanordnung wird auf die Substratschicht aufgebracht.

Gemäß einer Weiterbildung des Verfahrens wird die Schichtstruktur mit mehreren Halbleiterschichten bereitgestellt, indem die zweite Schichtanordnung auf der Substratschicht aufgebracht wird oder in die Substratschicht integriert wird.

Gemäß einer anderen Ausführungsform des Verfahrens wird die zweite Schichtstruktur auf der Substratschicht durch Schichtabscheidung aufgebracht oder durch Ionenimplantation in die Substratschicht integriert.

Weitere Merkmale, vorteilhafte Ausgestaltungen und Zweckmäßigkeiten der Erfindung ergeben sich aus der folgenden Beschreibung der Ausführungsbeispiele in Verbindung mit den. Figuren.
- Figur 1: zeigt eine erste Ausführungsform eines optoelektonischen Moduls,
- Figur 2A: zeigt eine Draufsicht auf eine zweite Ausführungsform eines optoelektronischen Moduls mit einer ESD-Schutzschaltung,
- Figur 2B: zeigt einen Schnitt durch die zweite Ausführungsform des optoelektronischen Moduls mit einer ESD-Schutzschaltung,
- Figur 3: zeigt eine dritte Ausführungsform eines optoelektronischen Moduls,
- Figur 4: zeigt Licht emittierende Schichten, die auf einer Trägerschicht aufgewachsen sind,
- Figur 5: zeigt ein vorstrukturiertes Trägersubstrat, in das Schaltungen zur Steuerung einer Lichtemission von Licht emittierenden Schichten integriert sind,
- Figur 6: zeigt eine optoelektronische Modulanordnung mit mehreren integrierten optoelektronischen Modulen.

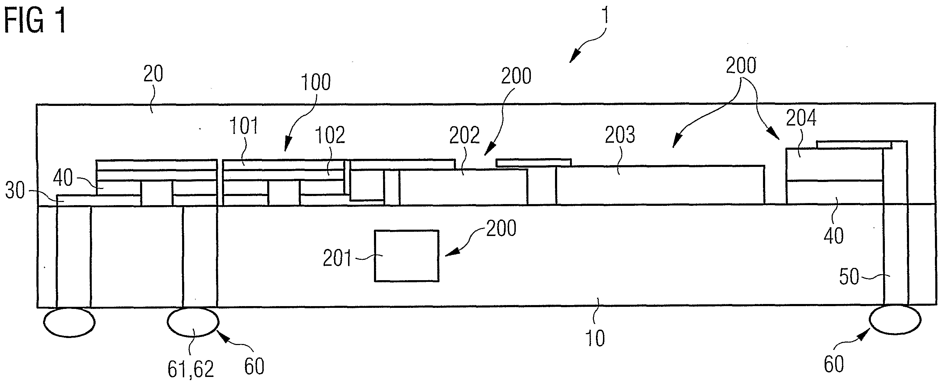

Figur 1 zeigt eine Ausführungsform eines optoelektronischen Moduls 1 mit einer integrierten Schaltung mit aktiven und passiven elektronischen Komponenten 200, die in einer Träger-Substratschicht vorstrukturiert sind. Die Träger-Substratschicht 10 ist beispielsweise ein Si-Wafer, in/auf dem die verschiedenen integrierten Schaltkreise 200 vorstrukturiert sind. Die Vorstrukturierung des Trägersubstrats geschieht bereits im Frontend auf Waferebene, sodass ein optoelektronisches Modul mit einer integrierten Schaltung entsteht.

Auf der Träger-Substratschicht 10 wird eine Licht emittierende Halbleiterschichtstruktur 100 aufgebracht. Die Halbleiterschichtstruktur 100 umfasst beispielsweise Licht emittierende Schichten 101, 102. Die Halbleiterschichtstruktur 100 kann beispielsweise einen oder mehrere LED-Chips enthalten, die beispielsweise rotes, grünes oder blaues Licht abstrahlen. Jeder LED-Chip ist mittels einer Befestigungsschicht 40 auf der Träger-Substratschicht 10 befestigt. Als strahlungsemittierende Bauelemente 100 können auf der Träger-Substratschicht 10 beispielsweise organische Leuchtdioden (OLED), Hochleistungs-LED oder CSP-Leuchtdioden angeordnet werden.

Die Licht emittierende Halbleiterschichtstruktur 100 kann auch beispielsweise eine substratlose LED sein. Die Licht emittierenden Schichten 101, 102 sind bei substratlosen LEDs nicht mehr auf einem Trägermaterial des Trägers 10, beispielsweise einem Germanium- oder Siliziumträger, angeordnet, sondern sind direkt auf dem Träger aufgebracht. Die Licht emittierende Halbleiterschichtstruktur 100 kann auf die Träger-Substratschicht 10 geklebt oder gelötet sein. Durch die Verwendung von derartigen LED-Chips ohne Substrat und Vorderseitenkontakt wird ein flacher homogener Aufbau des optoelektronischen Moduls ermöglicht.

Wenn die Halbleiterschichtstruktur 100 auf die Träger-Substratschicht 10 aufgebracht wird, ist die Träger-Substratschicht bereits vorstrukturiert. Die Vorstrukturierung erfolgt, indem im Frontend weitere Schichtanordnungen 200 in oder auf der Träger-Substratschicht 10 aufgebracht werden. In der Träger-Substratschicht 10, beispielsweise in einem Si-Halbleiterwafer, kann beispielsweise im Frontend eine Schichtanordnung 201 eingebracht werden, die als eine Schaltung zum Schutz der Licht emittierenden Halbleiterschichtstruktur 100 beziehungsweise zum Schutz weiterer in oder auf der Träger-Substratschicht 10 aufgebrachter integrierter Schaltungen vor elektrostatischer Entladung ausgebildet ist. Die in die Träger-Substratschicht 10 integrierte Schichtanordnung 201 kann zum Beispiel eine integrierte Schutzdiode sein. Des Weiteren kann die Schaltung 201 ESD-Filter umfassen, die in die Substratschicht 10 integriert sind.

Bei dem in Figur 1 dargestellten optoelektronischen Modul 1 sind auf der Träger-Substratschicht 10 beispielsweise zwei Licht emittierende Halbleiterschichtstrukturen 100, beispielsweise LED-Chips, aufgebracht. Das optoelektronische Modul kann weitere LED-Chips aufweisen. Zur Steuerung einer Abstrahlcharakteristik, einer Helligkeit oder einer von den Licht emittierenden Schichten 101, 102 der LED-Chips abgestrahlten Farbe kann eine weitere Schichtanordnung 202 bei der Herstellung des optoelektronischen Moduls im Frontend auf der Träger-Substratschicht 10 angeordnet werden. Durch die Schichtanordnung 202 lässt sich beispielsweise eine integrierte Schaltkreisstruktur realisieren, durch die es ermöglicht wird, die mehreren auf der Träger-Substratschicht 10 angeordneten LED-Chips 100 in ihrer Helligkeit, Farbe und Abstrahlcharakteristik aufeinander abzustimmen. Dadurch können ungewünschte Effekte durch einzelne auffällig farbstichige Beleuchtungskörper homogenisiert werden.

Bei der in Figur 1 gezeigten Ausführungsform des optoelektronischen Moduls ist auf der Träger-Substratschicht 10 eine weitere Schichtanordnung 203 aufgebracht. Die Schichtanordnung 203 enthält beispielsweise den Schaltkreis einer Fotodiode. Die Schichtanordnung 203 wird ebenfalls bereits bei der photolithografischen Herstellung des optoelektronischen Moduls im Frontend auf der Träger-Substratschicht 10 angeordnet.

Bisher war es erforderlich, dass zur Erzeugung einer homogenen Abstrahlcharakteristik der einzelnen LED-Chips im Produktionsprozess vor der Modulbestückung Gruppen von LED-Chips sortiert worden sind, die ein gleiches oder zumindest ein ähnliches Abstrahlverhalten in Bezug auf Helligkeit und Farbe (Wellenlänge) aufweisen. Durch die Fotodiode 203 kann bei dem in Figur 1 dargestellten optoelektronischen Modul die Umgebungshelligkeit erfasst werden. Dadurch wird es ermöglicht, die Lichtabstrahlung der Licht emittierenden Schichten 100 auf die vorherrschende Umgebungshelligkeit abzustimmen. Die Abstimmung erfolgt mittels der Steuerschaltung 202, die die Helligkeit, Farbe und Abstrahlcharakteristik der LED-Chips 100 steuert. Durch die Anpassung der Abstrahlung der LED-Chips kann eine teure und nur mit großem Aufwand durchzuführende Feinstgruppierung der LED-Chips, die bisher bei einem Modul ohne Regelung erforderlich war, vermieden werden.

Durch die Regelung der Abstrahlparameter der einzelnen Licht emittierenden Schichten 101, 102 können Abweichungen in der Abstrahlcharakteristik der einzelnen Leuchtdioden in einer Endanwendung kostengünstig und effektiv korrigiert werden. Somit kann auch ein bisher unverkäuflicher Ausfall an LED-Bauteilen noch verwendet werden. Ebenso können störende Einflüsse von Linsen oder Farbweichungen von Konversionsstoffen, die beispielsweise über den Licht emittierenden Halbleiterschichtstrukturen 100 angeordnet sind, kompensiert werden. In Abhängigkeit von den Betriebsbedingungen und Fertigungsstreuungen der Licht emittierenden Schichten und nicht zuletzt nach dem Wunsch des Anwenders oder Produzenten kann die Abstrahlcharakteristik vor Ort oder im Werk abgestimmt und eingestellt werden.

Auf der Träger-Substratschicht 10 kann eine weitere Schichtanordnung 204 aufgebracht sein. Die Schichtanordnung 204 wird ebenfalls wie die Schichtanordnung 201, 202 und 203 bereits im Frontend durch photolithografische Prozesse auf der Träger-Substratschicht 10 aufgebracht. Durch die Schichtanordnung 204 kann eine Schaltungsstruktur in das optoelektronische Modul 1 integriert werden, die zur Strom-/ Spannungsregelung der Licht emittierenden Schichtstruktur 100 beziehungsweise der weiteren aktiven integrierten Schaltungen, beispielsweise der Steuerschaltung 202, dient.

Bei der Schaltungsstruktur 204 kann es sich auch um eine Schaltung handeln, die zur Stromstabilisierung und Leistungsstabilisierung der Licht emittierenden Schichten verwendet wird. Die Schaltungsstruktur 204 ist beispielsweise über eine Befestigungsschicht 40 auf der Träger-Substratschicht 10 angeordnet.

Zur Kontaktierung des optoelektronischen Moduls 1 sind in der Träger-Substratschicht 10 Verbindungsleiter 50, so genannte Vias, vorgesehen. Auf der Rückseite der Träger-Substratschicht sind Kontakte 60 zur späteren Lot-Kontaktierung angeordnet, die mit den Vias 50 verbunden sind. Die Kontakte können beispielsweise Bump-Kontakte 61 oder Bondpad-Kontakte 62 sein.

Zur Verbindung der Schichtanordnungen 100 und 200 untereinander beziehungsweise mit den Kontakten 60 ist auf der Träger-Substratschicht 10 eine weitere Schichtanordnung vorgesehen. Die Schichtanordnung kann beispielsweise als Leiterbahn 30 auf die Träger-Substratschicht 10 aufgedampft oder aufgesputtert werden.

Zum Schutz der Strukturen 100 und 200 ist bei der in Figur 1 gezeigten Ausführungsform über dem Trägersubstrat 10 eine strahlungsdurchlässige Schutzschicht 20 aufgebracht. Die Schutzschicht 20 kann zum Beispiel ein Acryl-, ein Epoxid- oder ein Silikonharz oder ein Silikon enthalten. In die Schutzschicht 20 können Lumineszenzkonversionspartikel eingebettet sein.

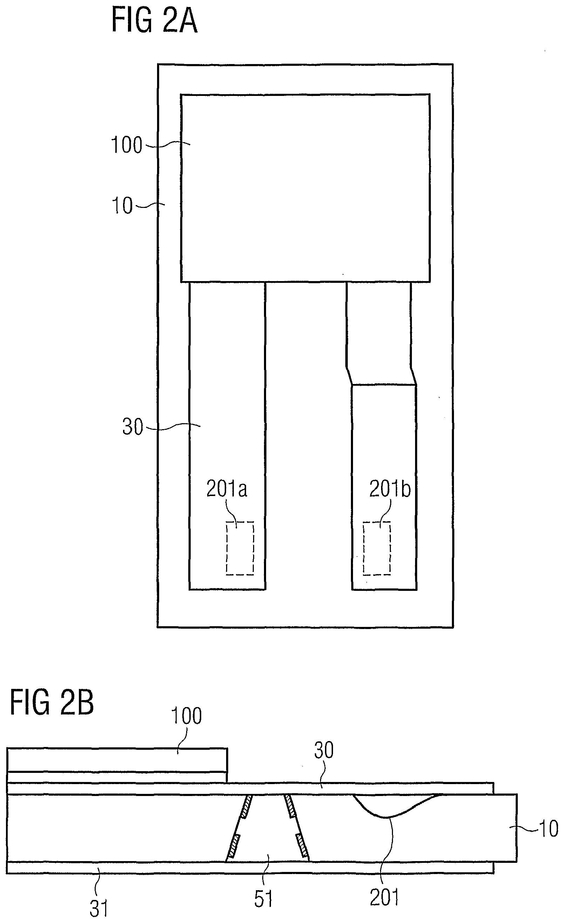

Figur 2A zeigt eine Ausführungsform eines optoelektronischen Moduls, das in Figur 2B in einer Schnittzeichnung dargestellt ist. Eine Licht emittierende Halbleiterschichtstruktur 100 ist auf einer Oberseite einer Substratschicht 10, beispielsweise einer Si-Schicht, angeordnet. Die Halbleiterschichtstruktur 100 ist mit Leiterbahnen 30 verbunden, die ebenfalls auf der Oberseite der Substratschicht 10 angeordnet sind. Die Leiterbahnen 30 können beispielsweise als Kontaktanschlüsse aus Gold ausgeführt sein. Die Kontaktanschlüsse sind über die Durchkontaktierungslöcher 51 mit einem Rückseitenkontakt 31 verbunden. Der Rückseitenkontakt kann eine metallische Schicht, beispielsweise eine Goldschicht, sein.

Unter einer Teilfläche der Kontaktanschlüsse befindet sich eine Schichtanordnung 201. Die Schichtanordnung 201 kann beispielsweise die in Figur 2A gezeigten dotierten Bereiche 201a und 201b umfassen, die durch Ionenimplantation in der Substratschicht 10 gebildet werden. Die Schichtstruktur aus den dotierten Bereichen 201a und 201b bildet eine ESD-Schutzdiode, beispielsweise eine Schottky-Diode. Die Eigenschaften der Diode lassen sich bei der Herstellung der dotierten Bereiche 201a und 201b durch Modifikation der Abmessungen der dotierten Bereiche und des Abstands der dotierten Bereiche vorgeben.

Bezüglich der Durchlassrichtung ist die ESD-Schutzdiode 201 antiparallel zu der Durchlassrichtung der Diodenstruktur der Licht emittierenden Halbleiterschichtstruktur 100 angeordnet. Bei einer elektrostatischen Aufladung der Diodenstruktur der Halbleiterschichten 100 können Ladungsträger über die in die Substratschicht 10 eingebettete ESD-Schutzdiode 201 abgeführt werden.

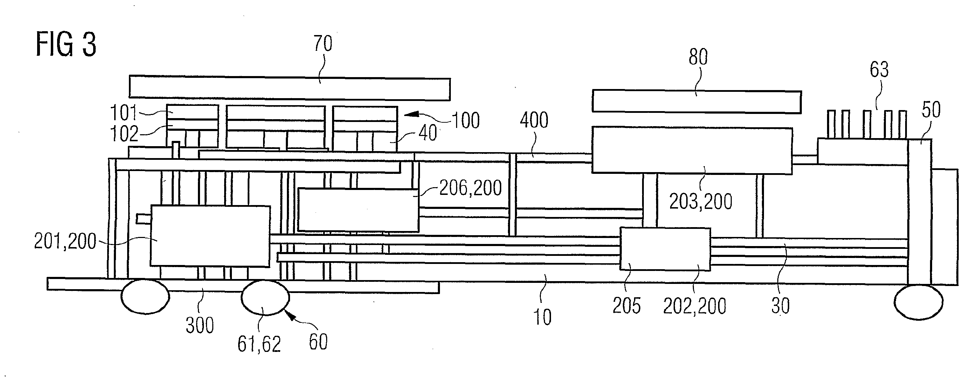

Figur 3 zeigt eine weitere Ausführungsform eines optoelektronischen Moduls 1. Bei der in Figur 3 gezeigten Ausführungsform des optoelektronischen Moduls sind in eine Träger-Substratschicht 10 weitere Schichtanordnungen 201, 202, 205, 206 durch photolithografische Prozesse im Frontend integriert worden. Die Schichtanordnungen realisieren integrierte Schaltkreise, die zum ESD-Schutz und zur Steuerung/Regelung der Licht emittierenden Schichten 100 dienen.

Die Licht emittierenden Schichten 100, die beispielsweise LED-Chips sein können, sind ähnlich wie bei der in Figur 1 gezeigten Ausführungsform auf der Träger-Substratschicht 10 angeordnet. Die LEDs sind beispielsweise auf die Substratschicht geklebt oder gelötet. Die Licht emittierenden Schichten können beispielsweise als organische Leuchtdioden (OLED), Hochleistungs-Leuchtdioden oder CSP-Leuchtdioden ausgebildet sein. Über den Licht emittierenden Schichten 100 kann ein Streuer oder Konverter 70 angeordnet sein. Durch einen derartigen Konverter 70 kann die von den Licht emittierenden Schichten 101, 102 der Schichtanordnung 100 erzeugte Strahlung in Strahlung einer anderen Wellenlänge umgewandelt werden. Das optoelektronische Modul kann dadurch mischfarbiges, vorzugsweise weißes, Licht abstrahlen.

Zur Steuerung einer Abstrahlcharakteristik der einzelnen Licht emittierenden Schichten 101, 102, insbesondere zur Steuerung einer Helligkeit und Farbe des abgestrahlten Lichts, ist bei der Herstellung des optoelektronischen Moduls im Frontend in die Träger-Substratschicht 10 eine Schichtanordnung 202 integriert worden. Durch die Steuerschaltung 202 wird es beispielsweise ermöglicht, eine Farbmischung des von den Licht emittierenden Schichten 101, 102 abgestrahlten Lichts zu erzeugen. Dadurch wird, insbesondere dann, wenn mehrere LED-Strukturen 100 auf dem Trägersubstrat 10 abgeordnet sind, eine Weißpunktfindung ermöglicht.

Die Steuerung der Lichtemission der Licht emittierenden Halbleiterschichtstruktur 100 kann zum Beispiel in Abhängigkeit von einer Temperatur erfolgen. Dazu kann in der Schichtanordnung 202 ein Schaltkreis 205 zur Erfassung der Temperatur des optoelektronischen Moduls enthalten sein.

Die Steuerung der Abstrahlcharakteristik der Licht emittierenden Schichten 100 kann in Abhängigkeit von der Umgebungshelligkeit erfolgen. Dazu ist auf der Oberseite der Träger-Substratschicht 10 durch photolithografische Prozesse eine Schichtanordnung 203 aufgebracht, die beispielsweise als Fotodiodenschaltung ausgebildet ist. Über der Fotodiode kann ein optisches Element 80, vorzugsweise ein Element zur Strahlformung, beispielsweise eine Linse, angeordnet sein. Nach Auswertung der von der Fotodiode erfassten Helligkeit der Umgebung regelt die Steuerschaltung 202 die Lichterzeugung der Licht emittierenden Schichten 100.

Eine Änderung der Lichtabstrahlung kann bei einer weiteren Ausführungsform über eine Funkfernsteuerung durch einen Nutzer erfolgen. Dazu kann die Schichtanordnung 202 eine Empfangsschaltung zum Empfang von Steuersignalen enthalten, die von einer Sendeeinheit über eine Funkverbindung übertragen worden sind.

Zum Schutz der aktiven in oder auf der Träger-Substratschicht 10 integrierten Schaltungsstrukturen sowie der Licht emittierenden Schichten 101, 102 vor einer Zerstörung infolge einer elektrostatischen Entladung ist in der Substratschicht 10 eine Schichtanordnung 201 vorstrukturiert. Mit der Schichtanordnung 201 wird eine ESD-Schutzschaltung realisiert. Die ESD-Schutzschaltung kann beispielsweise eine in die Substratschicht 10 integrierte Schutzdiode sein. Mit der Schaltungsstruktur 201 können auch ESD-Filter realisiert werden. Die Schaltungsstruktur 201 kann auch ein sonstiges passives Netz sein, das bereits im Frontend bei der Fertigung der Träger-Substratschicht 10 durch photolithografische Prozesse in den Wafer 10 integriert worden ist.

Zur Abführung von Wärme, die von den Schaltungsstrukturen 200 des optoelektronischen Moduls sowie von den Licht emittierenden Halbleiterstrukturen 100 erzeugt worden ist, ist eine Wärmesenke 300 vorgesehen. Die LED-Halbleiterstrukturen 100 sind mit der Wärmesenke verbunden. Die Wärmesenke 300 kann eine Hochleistungswärmesenke sein, die zum Beispiel aus einem kohlenstoffartigen Diamant gebildet ist. Die Wärmesenke kann in der Substratschicht 10 beziehungsweise an der Oberseite der Substratschicht, beispielsweise eines Siliziumwafers, integriert sein.

Weiterhin kann auch im rückwärtigen Teil des Siliziumsubmounts 10 eine aktive oder passive Kühleinrichtung integriert sein. Zur aktiven Kühlung von Elementen des optoelektronischen Moduls können beispielsweise auch Mikropumpen 206 in die Träger-Substratschicht 10 integriert sein. Es können weitere mikro-elektrische-mechanische Systeme bei der Fertigung des optoelektronischen Moduls in oder auf der Substratschicht 10 bereits bei der Waferbearbeitung im Frontend integriert beziehungsweise vorstrukturiert werden, bevor die LEDs auf die Oberseite der Substratschicht 10 geklebt oder gelötet werden. Zu derartigen Systemen gehören beispielsweise auch Hochleistungssiliziumrelaisschaltungen oder Solarzellen als Stromversorgung, insbesondere für kleine unzugängliche Kontrollmodule.

Die LED-Strukturen 100 sind mit den in oder auf dem Wafer vorstrukturierten beziehungsweise integrierten Schaltungsstrukturen 200 über Verdrahtungsebenen, die Leiterbahnen 30 enthalten, verbunden. Die LEDs können auch über die Leiterbahnen 30 mit Steuer- und Regelelementen verbunden sein, die in die Waferrückseite integriert sind. In die Rückseite des Siliziumsubmounts können ferner programmierbare speicherfähige Logikschaltelemente integriert sein. Diese Regel- beziehungsweise Schaltelemente können ebenfalls funkferngesteuert oder über Leiterbahnen 30 programmiert werden oder stationär sein. Anstelle der Rückseite kann auch die Integration in die Vorderseite genügen. Bei großem Siliziumschaltungsaufwand können mehrere Si-Lagen gestackt sein. Durch diese Logikbeschaltung kann der Betriebspunkt des optoelektronischen Moduls anwendungsspezifisch eingestellt werden. Die Trimmung des optoelektronischen Moduls 1 kann auch dauerhaft im Werk geschehen. Alterungsvorgänge können damit ausgeglichen werden.

Zur Kontaktierung der optoelektronischen integrierten Schaltung sind externe Anschlüsse 60 vorgesehen, die als Bump-Kontakte 61 oder Bondpad-Kontakte 62 ausgebildet sein können. Zur Verbindung der externen Anschlüsse mit den Schaltungsstrukturen des optoelektronischen Moduls sind innerhalb der Substratschicht 10 Verbindungsleiter (Vias) 50 vorgesehen. Zur Verbindung des integrierten optoelektronischen Moduls 1 mit weiteren integrierten optoelektronischen Modulen zu einer Modulanordnung können beispielsweise auf der Oberseite der Träger-Substratschicht 10, beispielsweise auf einer Seite der Träger-Substratschicht nicht direkt im optischen Strahlengang, Anschlüsse 63 zur Modulzwischenverbindung vorgesehen sein. Die Anschlüsse 63 können beispielsweise als elektrische, mechanische oder optische Steck- oder Schraubverbindungen ausgeführt sein.

Als Materialien für die Träger-Substratschicht 10 wird vorzugsweise Si, SiC, Ge, GaN verwendet. Des Weiteren kann das Trägermaterial Aluminiumnitrid, Aluminiumoxid oder Siliziumnitrid aufweisen. Um zu verhindern, dass das von den Licht erzeugenden Schichten generierte Licht freie Ladungsträger in der als Halbleiterwafer ausgebildeten Trägerschicht erzeugt, ist die Träger-Substratschicht 10 mit einer Passivierungsschicht 400, insbesondere an der Oberseite im Bereich der Licht emittierenden Schichten 100, überzogen. Über der Passivierungsschicht 400 können weitere Schutzschichten, Konversionsschichten, Antireflexschichten oder weitere optische Elemente angeordnet sein.

Anstelle der Verwendung eines Siliziumwafers kann als Träger-Substratschicht 10 auch eine flexible Folie verwendet werden. Die Folie kann aufgeklebt werden. Die Wärmeabfuhr beziehungsweise Stromversorgung kann bei dieser Ausführungsform über geeignete Bänder geregelt sein.

Die in den Figuren 1, 2 und 3 gezeigten Ausführungsformen des optoelektronischen Moduls können in einem Gehäuse angeordnet werden. In vielen Fällen ist ein Gehäuse nicht mehr nötig. Die Module können beispielsweise direkt in eine Halogenretrofitfassung verbracht werden.

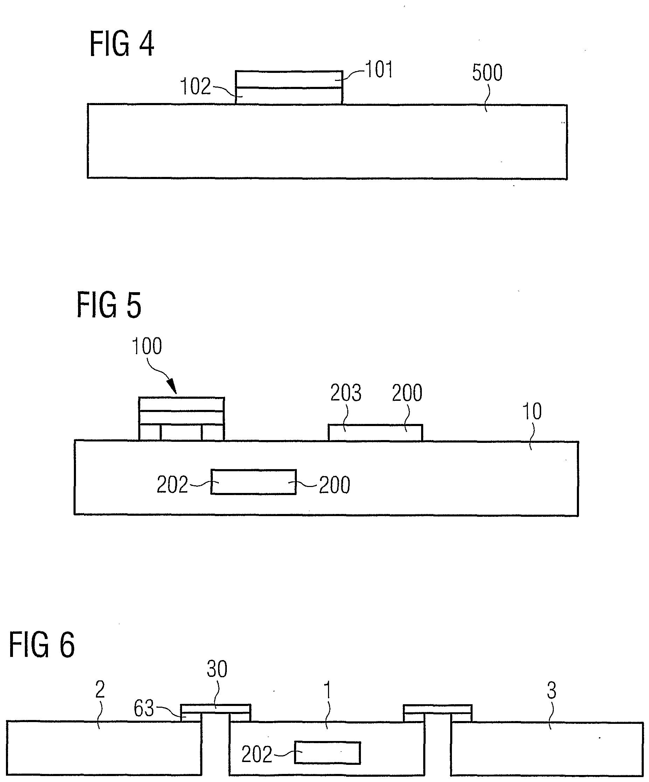

Die Figuren 4 und 5 veranschaulichen ein Herstellungsverfahren zur Herstellung eines optoelektronischen Moduls, wie in den Figuren 1, 2 und 3 gezeigt. Figur 4 zeigt eine Trägerschicht 500, auf der eine Schichtanordnung 100 mit Licht emittierenden Schichten 101, 102 aufgewachsen ist. Die Licht emittierenden Schichten können beispielsweise Epischichten sein, die auf einem Saphir als Trägerschicht aufwachsen. Die Licht emittierenden Schichten 101 und 102 werden von der Trägerschicht 500 abgehoben und mit Kontakten, beispielsweise mit Metallkontakten, versehen.

Wie in Figur 5 veranschaulicht, werden die LED-Chips, die die Licht emittierenden Schichten mit den Metallkontakten umfassen, auf einer vorstrukturierten Träger-Substratschicht 10 angeordnet. Die Träger-Substratschicht 10 kann beispielsweise ein Siliziumwafer sein, in den bereits bei der Fertigung des Wafers im Frontend Schaltkreise 200, wie anhand der Figuren 1, 2 und 3 beschrieben, integriert worden sind. Die Schaltkreise 200 können beispielsweise Steuer- und Regelungsschaltungen zur Steuerung einer Abstrahlcharakteristik, einer Helligkeit oder einer Farbmischung der LED-Chips oder ESD-Schutzschaltungen sein. Zur Steuerung der Helligkeit der Strahlung, die von den LED-Chips 100 erzeugt wird, kann der Halbleiterwafer 10 bereits im Frontend mit einer als Fotodiode ausgebildeten Schichtanordnung vorstrukturiert worden sein. Die einzelnen anhand der Figuren 1, 2 und 3 beschriebenen Schaltkreise 201, 202, 203, 204, 205, 206 und 207 können zum Beispiel durch ein photolithografisches Verfahren bei der Herstellung beziehungsweise Bearbeitung des Halbleiterwafers 10 integriert werden. Die Schaltkreise werden beispielsweise als Schichtstrukturen durch Abscheidung von einzelnen Schichten auf der Träger-Substratschicht 10 aufgebracht. Des Weiteren können Schichten direkt in das Trägersubstrat durch Dotierprozesse oder durch Ionenimplantation integriert werden.

Bei der Herstellung eines optoelektronischen Moduls werden möglichst viele Komponenten direkt auf oder in dem Trägersubstrat 10 in Frontend-Prozessen integriert. Neben den in Figur 5 gezeigten Schaltungen können auch Logikschaltungen, Vias, Wärmeleitungsschichten sowie Kontaktierungen, insbesondere Bondpad- und Bumpkontakte zur späteren Lot-Kontaktierung auf oder in dem Halbleiterwafer vorstrukturiert werden. Dadurch wird das Aufbringen von Einzelbauteilen, beispielsweise mittels eines Pick-and-Place-Verfahrens, vermieden. Da die funktionalen Einheiten parallel auf einem Wafer integriert aufgebaut und erst am Ende der Fertigung getrennt werden, sind derartige optoelektronische Module besonders kompakt und kostengünstig in der Herstellung.

Figur 6 zeigt eine Ausführungsform einer Modulanordnung, bei der mehrere optoelektronische Module 1, 2 und 3 miteinander verbunden sind. Die zu der Modulanordnung zugehörigen einzelnen optoelektronischen Module können beispielsweise den in den Figuren 1, 2 oder 3 gezeigten Aufbau aufweisen. Die optoelektronischen Module sind über die Modulzwischenverbindungen 63 miteinander verbunden.

Bei der in Figur 6 gezeigten Modulanordnung weist das optoelektronische Modul 1 einen integrierten Steuerschaltkreis 202 auf, der in der Träger-Substratschicht 10 vorstrukturiert ist. Die Steuerschaltung 202 dient der Steuerung der gesamten Modulanordnung. Die einzelnen optoelektronischen Module 1, 2 und 3 lassen sich autonom oder gekoppelt aufeinander oder auf die Umgebung, beispielsweise auf die Helligkeit der Umgebung, abstimmen. Somit lassen sich zum Beispiel Räume erhellen mit von Beleuchtungskörper zu Beleuchtungskörper homogener warm- oder kaltweißer Strahlung. Effekte durch einzelne auffällig farbstichige Beleuchtungskörper können homogenisiert werden.

Durch den Einsatz der in die Träger-Substratschicht 10 integrierten Steuerschaltung 202 lässt sich die in Figur 6 gezeigte Modulanordnung in einer Master/Slave-Technik betreiben. Dadurch kann beispielsweise eine Farbmischung und somit eine Weißpunktfindung in der Modulanordnung und korrespondierend auch zu anderen Modulen erfolgen.

Die in Figur 6 gezeigten Modulanordnungen können beispielsweise zur Beleuchtung eines Raumes oder eines Teil des Raumes, zum Beispiel zur Beleuchtung einer Nahrungsmitteltheke, verwendet werden. Durch die Möglichkeit, die Modulanordnung in Master-/Slave-Technik zu betreiben, wird es ermöglicht, die einzelnen auf den optoelektronischen Modulen angeordneten LED-Chips derart anzusteuern, dass beispielsweise alle Nahrungsmittel gleichmäßig unabhängig von der Umgebungshelligkeit und dem Inhalt der Theke beleuchtet werden. Die Masterschaltung kann beispielsweise die angeschlossenen integrierten Schaltkreise der einzelnen Module derart ansteuern, dass ein Stromsparprogramm aktiviert wird, wenn sich beispielsweise keine Kunden vor der Theke aufhalten.

Durch die Möglichkeit, die Abstrahlcharakteristik der Leuchtdioden zu verändern, ist es beispielsweise auch möglich, Alterungseffekte der Leuchtdioden auszugleichen, insbesondere zum Beispiel dann, wenn rote Dioden anfangs heller und später überproportional dunkler leuchten, als blaue Leuchtdioden in derselben Modulanordnung. Durch die Steuerung und Regelung der Abstrahlcharakteristik lässt sich die Farbmischung variieren, sodass beispielsweise eine grünstichige Beleuchtung von Fleischwaren in einer Nahrungsmitteltheke zuverlässig vermieden werden kann.

Diese Patentanmeldung beansprucht die Prioritäten der deutschen Patentanmeldungen 102008024927.0 und 102008049777. 0

Die Erfindung ist nicht durch die Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist. Die Erfindung ist in den Ansprüchen definiert.

## Patentansprüche

1. Optoelektronisches Modul, umfassend:
- eine Schichtstruktur mit mehreren Halbleiterschichten (10, 20, 100, 200) umfassend eine Substratschicht (10), eine erste Schichtanordnung (100) und eine zweite Schichtanordnung (200),
- wobei die erste Schichtanordnung (100) eine Licht emittierende Schicht (101, 102) aufweist, die auf der Substratschicht (10) angeordnet ist,
- wobei die zweite Schichtanordnung (200) mehrere Schaltungen (201, 202, 203, 204) zur Steuerung eines Betriebszustands der Licht emittierenden Schicht enthält, und
- wobei zumindest eine der Schaltungen (201, 202, 203, 204) von der Substratschicht (10) vollständig umgeben ist und zumindest eine der Schaltungen (201, 202, 203, 204) auf der Substratschicht (10) angeordnet oder von der Substratschicht (10) teilweise umgeben ist.

2. Optoelektronisches Modul nach Anspruch 1,
wobei zumindest eine Leiterbahn (30), die elektrisch leitend mit zumindest einer Schaltung der Schichtanordnung (200, 202, 203, 204) verbunden ist, von der Substratschicht (10) umgeben ist.

3. Optoelektronisches Modul nach einem der Ansprüche 1 bis 2,
wobei die zweite Schichtanordnung (200) eine Schaltung (202) zur Steuerung einer Helligkeit oder einer Farbe einer von der Licht emittierenden Schicht der ersten Schichtanordnung (100) emittierten Strahlung enthält.

4. Optoelektronisches Modul nach einem der Ansprüche 1 bis 3,
wobei die zweite Schichtanordnung (200) eine Schaltung (203) zur Detektion einer Helligkeit der Umgebung der integrierten Schaltung enthält.

5. Optoelektronisches Modul nach einem der Ansprüche 1 bis 4,
wobei die zweite Schichtanordnung (200) eine Schaltung (204) enthält, die zur Bereitstellung einer Spannung oder eines Stromes zur Erzeugung einer Strahlung der Licht emittierenden Schicht der ersten Schichtanordnung (100) ausgebildet ist.

6. Optoelektronisches Modul nach einem der Ansprüche 1 bis 5,
wobei die zweite Schichtanordnung (200) eine Schaltung (201) zum Schutz des optoelektronischen Moduls vor einer elektrostatischen Entladung und eine Schaltung (202) zur Steuerung einer Helligkeit oder einer Farbe einer von der Licht emittierenden Schicht der ersten Schichtanordnung (100) emittierten Strahlung und eine Schaltung (203) zur Detektion einer Helligkeit der Umgebung der integrierten Schaltung und eine Schaltung (204), die zur Bereitstellung einer Spannung oder eines Stromes zur Erzeugung einer Strahlung der Licht emittierenden Schicht der ersten Schichtanordnung (100) ausgebildet ist, enthält.

## Claims

1. Optoelectronic module comprising:
- a layer structure with a plurality of semiconductor layers (10, 20, 100, 200) comprising a substrate layer (10), a first layer assembly (100) and a second layer assembly (200),
- wherein the first layer assembly (100) comprises a light emitting layer (101, 102) disposed on the substrate layer (10),
- wherein the second layer assembly (200) comprises a plurality of circuits (201, 202, 203, 204) for controlling an operating state of the light emitting layer, and
- wherein at least one of the circuits (201, 202, 203, 204) is completely surrounded by the substrate layer (10) and at least one of the circuits (201, 202, 203, 204) is disposed on the substrate layer (10) or partially surrounded by the substrate layer (10).

2. Optoelectronic module according to claim 1,
wherein at least one conductor track (30) electrically conductively connected to at least one circuit of the layer arrangement (200, 202, 203, 204) is surrounded by the substrate layer (10).

3. Optoelectronic module according to any of claims 1 to 2, wherein the second layer assembly (200) comprises a circuit (202) for controlling a brightness or color of radiation emitted by the light emitting layer of the first layer assembly (100).

4. Optoelectronic module according to any of claims 1 to 3, wherein the second layer assembly (200) comprises a circuit (203) for detecting a brightness of the environment of the integrated circuit.

5. Optoelectronic module according to any of claims 1 to 4, wherein the second layer assembly (200) comprises a circuit (204) set up to provide a voltage or current for generating radiation of the light emitting layer of the first layer assembly (100).

6. Optoelectronic module according to any of claims 1 to 5, wherein the second layer assembly (200) comprises a circuit (201) for protecting the optoelectronic module from electrostatic discharge and a circuit (202) for controlling a brightness or color of radiation emitted by the light emitting layer of the first layer assembly (100) and a circuit (203) for detecting a brightness of the environment of the integrated circuit and a circuit (204) set up to provide a voltage or a current for generating a radiation of the light emitting layer of the first layer assembly (100).

## Revendications

1. Module optoélectronique, comprenant:
- une structure de couches comprenant une pluralité de couches semi-conductrices (10, 20, 100, 200) comportant une couche de substrat (10), un premier agencement de couche (100) et un second agencement de couche (200),
- le premier agencement de couche (100) comportant une couche (101, 102) émettrice de lumière disposée sur la couche de substrat (10),
- le second agencement de couche (200) comportant plusieurs circuits (201, 202, 203, 204) de commande d'un état de fonctionnement de la couche émettrice de lumière, et
- au moins un des circuits (201, 202, 203, 204) étant entièrement entouré par la couche de substrat (10) et au moins un des circuits (201, 202, 203, 204) étant disposé sur la couche de substrat (10) ou partiellement entouré par la couche de substrat (10).

2. Module optoélectronique selon la revendication 1,
dans lequel au moins une piste conductrice (30) qui est reliée de façon électriquement conductrice à au moins un circuit de l'agencement de couche (200, 202, 203, 204) est entourée par la couche de substrat (10).

3. Module optoélectronique selon l'une des revendications 1 à 2,
dans lequel le second agencement de couche (200) comporte un circuit (202) de commande d'une luminosité ou d'une couleur d'un rayonnement émis par la couche émettrice de lumière du premier agencement de couche (100) .

4. Module optoélectronique selon l'une des revendications 1 à 3,
dans lequel le second agencement de couche (200) comporte un circuit (203) de détection d'une luminosité de l'environnement du circuit intégré.

5. Module optoélectronique selon l'une des revendications 1 à 4,
dans lequel le second agencement de couche (200) comporte un circuit (204) configuré pour mettre à disposition une tension ou un courant pour générer un rayonnement de la couche émettrice de lumière du premier agencement de couche (100).

6. Module optoélectronique selon l'une des revendications 1 à 5,
dans lequel le second agencement de couche (200) comporte un circuit (201) de protection du module optoélectronique contre une décharge électrostatique et un circuit (202) de commande d'une luminosité ou une couleur d'un rayonnement émis par la couche émettrice de lumière du premier agencement de couche (100) et un circuit (203) de détection d'une luminosité de l'environnement du circuit intégré et un circuit (204) de mise à disposition d'une tension ou d'un courant pour générer un rayonnement de la couche émettrice de lumière du premier agencement de couche (100).
